# EUROPEAN PATENT APPLICATION

(11) **EP 4 064 806 A1**
(43) Date of publication of application: **28.09.2022**
(21) Application number: 22163771.3
(22) Date of filing: 23.03.2022
(51) Int. Cl.: H05K 7/14

(54) **ELECTRICAL COMPONENT COUPLING/DECOUPLING SENSOR ARRANGEMENT**

(30) Priority: 26.03.2021 US 202117213610
(71) Applicant: Rockwell Automation Technologies, Inc., Mayfield Heights, OH 44124-6188 (US)
(72) Inventor: Estanek, Brian T., Mayfield Heights (US); Lostoski, Douglas A., Mayfield Heights (US); Wrobel, Adam M., Mayfield Heights (US); Williams, Mark S., Mayfield Heights (US); Grech, John C., Mayfield Heights (US); Gierke, Justin T., Mayfield Heights (US); Overberger, Sean P., Mayfield Heights (US)
(74) Representative: Grünecker Patent- und Rechtsanwälte PartG mbB

(57) **Abstract**

An I/O system including an I/O base, and at least one I/O module mechanically and electrically coupled with the I/O base. The I/O module includes a locking actuator assembly having a locking actuator movable from a first unlocked position to a second locked position, the locking actuator configured to interlock with the I/O base to secure the I/O module to the base when in the second position, and a sensor for sensing a position of the locking actuator and generating a signal indicative of the position of the locking actuator.

## Description

### BACKGROUND INFORMATION

The subject matter disclosed herein relates to the field of automation control systems, such as those used in industrial and commercial settings. More particularly, embodiments of the present invention relate to techniques for providing, accessing, configuring, operating, or interfacing with input/output (I/O) devices that are configured for coupling and interaction with an automation controller.

Automation controllers are special purpose computers used for controlling industrial automation and the like. Under the direction of stored programs, a processor of the automation controller examines a series of inputs (e.g., electrical input signals to the automation controller) reflecting the status of a controlled process and changes outputs (e.g., electrical output signals from the automation controller) based on analysis and logic for affecting control of the controlled process. The stored control programs may be continuously executed in a series of execution cycles, executed periodically, or executed based on events. The inputs received by the automation controller from the controlled process and the outputs transmitted by the automation controller to the controlled process are normally passed through one or more I/O devices, which are components of an automation control system that serve as an electrical interface between the automation controller and the controlled process.

Traditional I/O devices typically include a base configured to couple the I/O device with a bus bar, communication bus, or the like, a terminal block for communicatively coupling the I/O device with field devices, and an I/O module that includes circuitry for performing communication functions and/or logic operations. In traditional automation control systems, the I/O module may be coupled to the base by pushing the module toward the base. Friction or a simple locking mechanism between parts of the I/O module and the base may help prevent the I/O module from disengaging from the base. In the past, locking toggle mechanisms have been employed to secure an I/O module to a base. In other arrangements, screws locking tabs or other fasteners are used to secure an I/O module to a base. The I/O module may be removed from the base by pulling the I/O module away from the base after releasing the locking mechanism, fastener or locking tab(s).

### BRIEF DESCRIPTION

It is now recognized that it is desirable to provide more efficient and effective techniques for coupling, locking, and uncoupling I/O modules from bases of I/O devices, or more generally coupling, locking and uncoupling a first electrical component from a second electrical component. In particular, some embodiments of the present disclosure employ a sensor configured to detect a position of a locking actuator of an electrical component and generate a signal indicative of the position of the locking actuator. The signal can be used to initiate actions such as a power up/power down routines, to switch a power supply associated with the electrical component from a startup mode (inefficient) to a switching mode (more efficient), and/or to inform a remaining electrical component in a redundant pair of components impending component removal.

In accordance with one aspect, an I/O system comprises a first electrical component and a second electrical component mechanically and electrically coupled with the first electrical component. The second electrical component (e.g., an I/O module) includes a locking actuator assembly having a locking actuator movable from a first unlocked position to a second locked position, the locking actuator configured to interlock with the first electrical component to secure the second electrical component to the first electrical component when in the second position, and a sensor for sensing a position of the locking actuator and generating a signal indicative of the position of the locking actuator.

The locking actuator assembly can include a shaft that is supported for rotation by the second electrical component and rotatable between the first and second positions, and the sensor can include a coil supported by the second electrical component and a metallic component supported by the shaft. The metallic component can be spaced apart from the coil a greater distance when the locking actuator is in the first position than when the locking actuator is in the second position whereby a change in the inductance of the coil corresponds to the signal indicative of the position of the locking actuator. The coil can extend in a plane parallel to a plane including the longitudinal axis of the shaft, the metallic component can be supported on a radially extending flange of the shaft such that the metallic component is rotated towards the coil when the shaft is rotated from the first position to the second position and rotated away from the coil when the shaft is rotated from the second position to the first position. The flange can extend in a parallel plane to the coil when the shaft is in the second position, and can extend in a non-parallel plane when the shaft is rotated from the second position towards the first position. The metallic component can include a metallic clip secured to the flange.

In another embodiment, the shaft can be supported by the second electrical component for axial and/or rotational movement, the first unlocked position corresponding to a first axial position of the shaft and the second locked position corresponding to a second axial position of the shaft. The metallic component can be included with a collar that is fixed for rotation with the shaft, said collar fixed to the second electrical component against axial movement such that the shaft is movable axially relative to the collar. The coil can be supported by the second electrical component in a location adjacent the collar, whereby the metallic component is spaced apart from the coil a greater distance when the locking actuator is in the first position than when the locking actuator is in the second position. The collar can be comprised of a composite material, and the metallic component can include a metallic clip secured to a flange of the collar.

In another exemplary embodiment, the locking actuator assembly includes at least one latch arm pivotally supported by a second electrical component (e.g., a backplane interface module) at a first end and having a latch flange spaced apart from the first end adapted to engage a surface of the first electrical component to thereby interlock the second electrical component with the first electrical component when the at least one latch arm is in the second position, the latch arm pivotable from the second position to the first position to disengage the latch flange from the first electrical component. The sensor includes a coil supported by the second electrical component and a metallic component supported by the latch arm, whereby the metallic component is spaced apart from the coil a greater distance when the locking actuator is in the first position than when the locking actuator is in the second position, and a change in the inductance of the coil corresponds to the signal indicative of the position of the locking actuator.

The sensor of any embodiment can include at least one of an inductive coil, a hall effect sensor, a photo interrupter, or a limit switch.

In accordance with another aspect, an electrical component comprises a connecter for electrically coupling with a corresponding connector of an associated mating electrical component, a locking actuator assembly for mechanically interlocking the electrical component with the associated mating electrical component, the locking actuator assembly includes a locking actuator movable from a first unlocked position to a second locked position, the locking actuator configured to interlock with the associated electrical component when in the second position, and a sensor for sensing a position of the locking actuator and generating a signal indicative of the position of the locking actuator.

The locking actuator assembly can include a shaft that is supported for rotation by the electrical component and rotatable between the first and second positions, and the sensor can include a coil supported by the electrical component and a metallic component supported by the shaft. The metallic component can be spaced apart from the coil a greater distance when the locking actuator is in the first position than when the locking actuator is in the second position, whereby a change in the inductance of the coil corresponds to the signal indicative of the position of the locking actuator. The coil can extend in a plane parallel to a plane including the longitudinal axis of the shaft, the metallic component being supported on a radially extending flange of the shaft such that the metallic component is rotated towards the coil when the shaft is rotated from the first position to the second position and rotated away from the coil when the shaft is rotated from the second position to the first position. The flange can extend in a parallel plane to the coil when the shaft is in the second position, and can extend in a non-parallel plane when the shaft is rotated from the second position towards the first position. The metallic component can include a metallic clip secured to the flange.

In another embodiment, the shaft can be supported by the electrical component for axial and/or rotational movement, the first unlocked position corresponding to a first axial position of the shaft and the second locked position corresponding to a second axial position of the shaft. The metallic component can be included with a collar that is fixed for rotation with the shaft, said collar fixed to the electrical component against axial movement such that the shaft is movable axially relative to the collar. The coil can be supported by the electrical component in a location adjacent the collar, whereby the metallic component is spaced apart from the coil a greater distance when the locking actuator is in the first position than when the locking actuator is in the second position. The collar can be comprised of a composite material, and the metallic component can include a metallic clip secured to a flange of the collar.

In another embodiment, the locking actuator assembly includes at least one latch arm pivotally supported by the electrical component at a first end and having a latch flange spaced apart from the first end adapted to engage a surface of the associated mating electrical component to thereby interlock the electrical component with the associated mating electrical component when the at least one latch arm is in the second position, the latch arm pivotable from the second position to the first position to disengage the latch flange from the associated mating electrical component. The sensor includes a coil supported by the electrical component and a metallic component supported by the latch arm, whereby the metallic component is spaced apart from the coil a greater distance when the locking actuator is in the first position than when the locking actuator is in the second position, whereby a change in the inductance of the coil corresponds to the signal indicative of the position of the locking actuator.

In accordance with another aspect, a method of determining a coupling state of a first electrical component with a second electrical component comprises sensing a position of a first locking actuator assembly of the first electrical component using a first sensor, and generating a first signal indicative of the position of the first locking actuator assembly. The first locking actuator assembly includes a first locking actuator movable from a first unlocked position to a second locked position, the first locking actuator configured to interlock the first electrical component with the second electrical component when in the second position, and the first sensor includes a coil supported by the first electrical component and a metallic component supported by first locking actuator. The metallic component is spaced apart from the coil a greater distance when the first locking actuator is in the first position than when the first locking actuator is in the second position, whereby a change in the inductance of the coil corresponds to the signal indicative of the position of the first locking actuator.

The method can further include sensing a position of a second locking actuator assembly of the first electrical component using a second sensor, and generating a second signal indicative of the position of the second locking actuator assembly. The second locking actuator assembly includes a second locking actuator movable from a first unlocked position to a second locked position, the second locking actuator configured to interlock the first electrical component with the second electrical component when in the second position. The second sensor includes a coil supported by the first electrical component and a metallic component supported by second locking actuator, whereby the metallic component is spaced apart from the coil a greater distance when the second locking actuator is in the first position than when the second locking actuator is in the second position, whereby a change in the inductance of the coil corresponds to the signal indicative of the position of the second locking actuator. The first and second signals are compared to determine whether the first electrical component is interlocked with the second electrical component.

### BRIEF DESCRIPTION OF THE DRAWINGS

FIGURE 1 is a diagrammatical representation of an exemplary control and monitoring system adapted to interface with networked components and configuration equipment in accordance with embodiments of the present techniques;
FIGURE 2 is a schematic diagram of distributed modular I/O system;
FIGURE 3 is a perspective view of an I/O device including redundant I/O modules in a duplex configuration;
FIGURE 4 is a perspective view of an exemplary circuit board assembly of an I/O module including a locking actuator assembly in an unlocked state in accordance with the present disclosure;
FIGURE 5 is a perspective view of the exemplary circuit board assembly of FIGURE 4 with the locking actuator assembly in a locked state;
FIGURE 6 is a perspective view of another exemplary circuit board assembly of an I/O module including a locking actuator assembly in an unlocked state in accordance with the present disclosure;
FIGURE 7 is a perspective view of the exemplary circuit board assembly of FIGURE 6 with the locking actuator assembly in a locked state;
FIGURE 8 is a side elevation view of the exemplary circuit board assembly of FIGURE 6;
FIGURE 9 is a front perspective view of an I/O base with a pair of backplane interface modules installed thereon;
FIGURE 10 is a rear perspective view of the I/O base and backplane interface modules of FIGURE 9;
FIGURE 11 is front elevation view of a backplane interface module with its housing removed showing a latch arm style locking actuator assembly in a latched position and a sensor in accordance with the present disclosure;
FIGURE 12 is front elevation view of a backplane interface module with its housing removed showing a latch arm style locking actuator assembly in an unlatched position and a sensor in accordance with the present disclosure;
FIGURE 13 is a perspective view of an exemplary internal structure of an Adapter module including two locking actuator assemblies and sensors in accordance with the present disclosure;
FIGURE 14 is an enlarged portion of FIGURE 13 showing one of the locking actuator assemblies in an unlocked position; and
FIGURE 15 is an enlarged portion of FIGURE 13 showing one of the locking actuator assemblies in a locked position.

### DETAILED DESCRIPTION

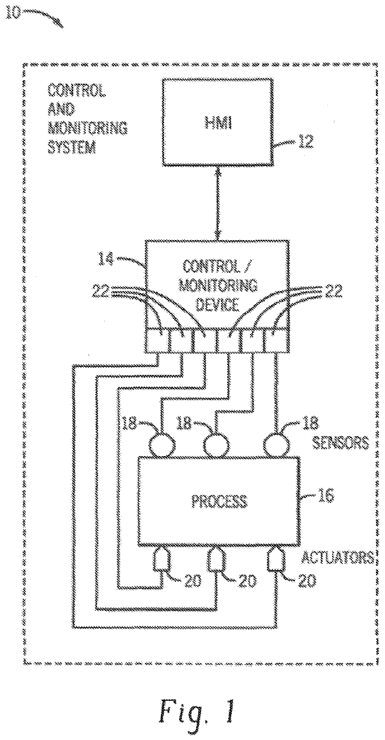

FIGURE 1 is a diagrammatical representation of a control and monitoring system adapted to interface with networked components and configuration equipment in accordance with embodiments of the present techniques. A full description of the system is set forth in commonly-assigned U.S. Pat. No 9,059,539, issue on June 16, 2015, which is hereby incorporated herein by reference in its entirety.

The control and monitoring system is generally indicated by reference numeral 10. Specifically, the control and monitoring system 10 is illustrated as including a human machine interface (HMI) 12 and an automation controller or control/monitoring device 14 adapted to interface with components of a process 16.

The illustrated process 16 includes sensors 18 and actuators 20. The sensors 18 can include any number of devices adapted to provide information regarding process conditions. The actuators 20 can include any number of devices adapted to perform a mechanical action in response to a signal from a controller (e.g., an automation controller). The sensors 18 and actuators 20 can be utilized to operate process equipment. Indeed, they can be utilized within process loops that are monitored and controlled by the control/monitoring device 14 and/or the HMI 12. Such a process loop can be activated based on process inputs (e.g., input from a sensor 18) or direct operator input received through the HMI 12.

As illustrated, the sensors 18 and actuators 20 are in communication with the control/monitoring device 14 and may be assigned a particular address in the control/monitoring device 14 that is accessible by the HMI 12. As illustrated, the sensors 18 and actuators 20 can communicate with the control/monitoring device 14 via one or more I/O devices 22 coupled to the control/monitoring device 14. The I/O devices 22 can transfer input and output signals between the control/monitoring device 14 and the controlled process 16. The I/O devices 22 can be integrated with the control/monitoring device 14, or can be added or removed via expansion slots, bays or other suitable mechanisms. For example, additional I/O devices 22 can be added to add functionality to the control/monitoring device 14.

The I/O devices 22 can include input modules that receive signals from input devices such as photo-sensors and proximity switches, output modules that use output signals to energize relays or to start motors, and bidirectional I/O modules, such as motion control modules which can direct motion devices and receive position or speed feedback. In some arrangements, the I/O devices 22 can convert between AC and DC analog signals used by devices on a controlled machine or process and DC logic signals used by the control/monitoring device 14.

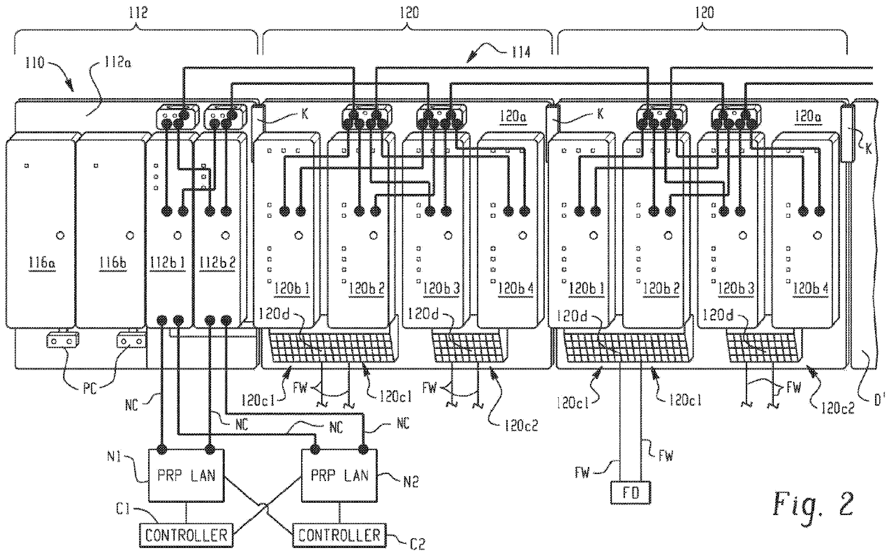

With reference to FIGURE 2, a distributed modular I/O system 110 in accordance with an embodiment of the present development. As described in detail below, the system 110 includes terminal block assemblies that permit an I/O base to operate in simplex mode, duplex mode or a combination thereof, as desired.

The distributed modular I/O system 110 includes a network adapter 112 that is operatively connected to both first and second redundant industrial automation networks N1,N2 such as first and second Parallel Redundancy Protocol (PRP) LAN networks or the like such as an Ethernet/IP network or other industrial automation network so that the network adapter 112 receives data from, transmits data to, and otherwise communicates with one or more industrial control modules or "controllers" C1,C2 connected respectively to the networks N1,N2. The controllers C1,C2 can comprise one or more programmable logic controllers (PLC), microprocessors, and/or other electronic processors for machine and/or process control.

The network adapter 112 includes an adapter base 112a that is mounted to a rail D' or other support structure. The network adapter 112 further comprises first and second redundant adapter modules 112b1,112b2 that are operating in parallel with each other and each of which is permanently or releasably connected to the adapter base 112a. Each adapter module 112b1,112b2 is connected to both the first and second networks N1,N2 and includes the electronic circuitry for data communication data with the controllers C1,C2 via networks N1,N2 and for data communication with multiple I/O devices 120 of the system 110 as described below. The adapter 112 comprises one or more network connectors NC for connecting with the networks N1,N2 via known connectors such as RJ45 connectors, Small FormFactor Pluggable (SFP) connectors, or the like.

The network adapter 112 further comprises first and second redundant power conditioning modules 116a, 116b connected to the adapter base 112a and each including a power input connector PC for connecting with a source of electrical power for supplying system electrical power to the network adapter 112 and to the I/O devices 120 and other components operatively connected to the adapter 112 and/or I/O devices 120.

The I/O system 110 further comprises one or more I/O devices 120 that each include an I/O base 120a also mounted to the support rail D' or other support structure, with a first I/O base 120a located adjacent and operably physically and electrically connected to the adapter base 112a by a multi-contact electrical connector K and with the additional I/O bases 120a operably physically and electrically connected together one after the other in a sequential manner by successive mating multi-contact electrical connectors K such that a modular backplane circuit or "backplane" (schematically illustrated at 114) is constructed and adapted for communicating electrical power and data through the successively connected I/O bases 120a and operably connects each I/O base 120a to the network adapter 112 and, thus, to the first and second networks N1,N2 and the first and second controllers C1,C2.

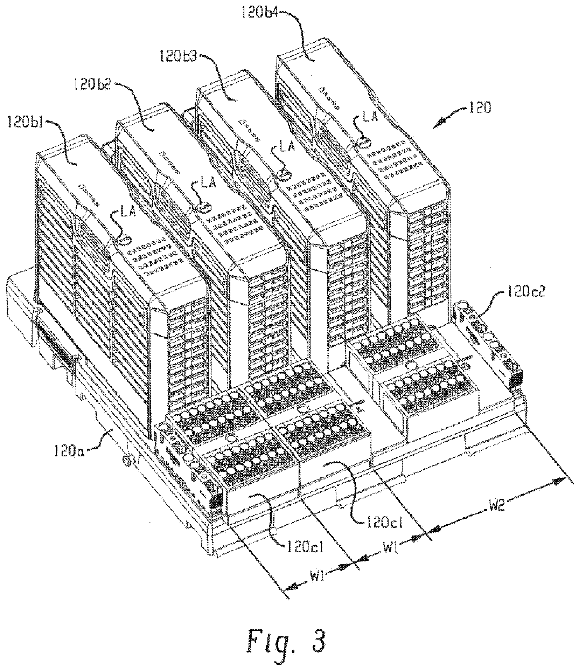

In addition to the I/O base 120a, each I/O device 120 further comprises at least two I/O modules 120b (120b1, 120b2, 120b3, 120b4, in FIG. 3) operatively removably connected to the I/O base 120a such that the installed I/O modules 120b also communicates with the network adapter 112 and the first and second controllers C1,C2 over the backplane 114a such that input/output data are provided between the controllers C1,C2 and each I/O module 120b via backplane 114a. Each installed I/O module 120b is selected and configured to perform one or more specialized input/output functions such as DC input, DC output, AC input, AC output, analog input and/or output, RTD and/or thermocouple input and/or thermocouple output, or the like as is generally known in the field of industrial automation.

In the illustrated embodiment, each I/O device 120 comprises four I/O modules 120b (120b1,120b2,120b3,120b4) operatively removably connected to the I/O base 120a, and at least two of the I/O modules 120b are identical to each other and operated in parallel to provide a redundancy with respect to each other (as shown, the I/O modules 120b3,120b4 of the two illustrated I/O devices 120 are identical and operated redundantly in parallel with respect to each other).

Each I/O base 120a further supports two types of terminal blocks 120c1 and 120c2 comprising a plurality of cage clamps, spring clamps, screw terminals, or other wiring connectors 120d that are adapted to be connected to field cables or field wires FW that are each associated with a field device FD that is typically an analog or digital device such as a sensor, flow meter, switch, probe, thermocouple, RTD, encoder, or the like that is associated with the process or machine being controlled (the controlled system CS) by the controllers C1,C2. In the illustrated embodiment, each terminal block 120c1/120c2 is a separate structure that is assembled to the I/O base 120a, but in some embodiments the terminal blocks can be defined as an integral or one-piece part of the I/O base 120a. Different varieties of terminal blocks can be used depending upon the particular configuration required for the field device wiring connectors 120d, with some having different common terminals, ground connections, voltage supply terminals, and the like. Each installed I/O module 120b communicates with the field device wiring connectors 120d of the same I/O base 120a on which the I/O module 120b is physically installed. Input/output data are provided between the controllers C1,C2 and field device(s) FD connected to the corresponding I/O base 120a via backplane 114 and the network adapter modules 112b1,112b2.

In the illustrated embodiment, the redundant, parallel I/O modules 120b3,120b4 share a common terminal block 120c2 such that the redundant I/O modules 120b3,120b4 are operably connected to the same field wiring FW and field device FD to send data to and receive data from the controlled system. I/O modules 120b1 and 120b2 are coupled to respective terminal blocks 120c1 for communication to respective field wiring FW. It should now be appreciated, that terminal blocks 120c1 and 120c2 differ in form and function from each other, with terminal block 120c1 configured to connect a single I/O module to associated field wiring FW (simplex mode) and terminal block 120c2 configured to couple two I/O modules to associated field wiring FW (duplex mode).

With additional reference to FIGURE 3, it will be appreciated that each of I/O modules 120b1 and 120b2 arc associated with a respective terminal block assembly 120c1 for connection to corresponding respective field wiring/devices (not shown), while both I/O modules 120b3 and 120b4 are associated with a common terminal block assembly 120c2 for connection to common field wiring/device (not shown). Terminal block assembly 120c1 has a width W1 that is approximately half of the width W2 of terminal block assembly 120c2. Each of the I/O modules 120b1, 120b2, 120b3 and 120h4 include a locking actuator assembly LA for mechanically securing the I/O module to the I/O base 120a.

The locking actuator assemblies LA of FIGURE 3 generally requires a user to rotate the actuator one-quarter turn to lock/unlock an I/O module to the I/O base. It should be appreciated that other types of locking mechanisms have also been used to secure I/O modules to an I/O base. For example, various locking tab arrangements have been proposed that allow an I/O module to be snap fit to an I/O base and subsequently released from the I/O base upon actuation of tabs or other mechanisms designed to disengage the snap fit components.

In I/O systems employing redundant I/O modules wherein a pair of I/O module is coupled to a common field device, it is sometimes necessary to remove and/or one of the I/O modules from the I/O base. In the past, removal of one of the I/O modules of a pair of I/O modules relied upon the redundant nature of the I/O system to accommodate any system disruption. That is, when an I/O module of a conventional system is removed, the remaining I/O module maintains system functionality. While suitable for many applications, there exist certain conditions within existing redundant I/O systems under which removal of an I/O module can result in less than optimal system performance.

In accordance with the present disclosure, an I/O module includes a locking actuator assembly and a sensor adapted to sense when the locking actuator assembly is moved from a locked position to an unlocked position and/or from the unlocked position to the locked position. The sensor can be configured to generate a signal indicative of the locking actuator being in the locked or unlocked position. The signal can be used by the I/O module or an associated I/O module to initiate one or more actions. In one exemplary configuration, a signal indicative of the locking actuator being in the locked position can be used to initiate a power-up sequencing. For example, an I/O module in accordance with the present disclosure can be initially connected to an I/O base but with the locking actuator assembly in an unlocked position. In this configuration, the system/circuitry of the I/O module can be held in a reset mode until the locking actuator is moved to the locked position. Once the sensor generates a signal indicative of the locking actuator being in the locked position, a power-up sequencing can be initiated. In another configuration, the signal can be used to switch a power supply associated with the I/O module from a startup mode (inefficient) to a switching mode (more efficient) when the locking actuator assembly is in the locked position. In another exemplary embodiment, a signal indicative of the locking actuator being in the unlocked position can be used to initiate a power-down sequencing of the I/O module, and/or can be used to instruct an associated remaining I/O module (of a pair) to take an action in preparation for the shutdown/removal of the I/O module. For the purposes of this discussion, it should be appreciated that sensing an absolute position of the locking actuator and/or a sensing a change in state of the locking actuator can be used in accordance with aspects of the present disclosure.

As will be appreciated, the locking actuators shown and described in connection with the remaining figures are each configured to engage with corresponding structure of an I/O base to secure an I/O module to the I/O base. The details of the interlocking structures of the locking actuator LA and I/O base are not germane to the sensing arrangement and have been omitted from the present disclosure. It should be understood that aspects of the sensing features of the present disclosure can be used in connection with a wide range of locking actuator styles and configurations.

With reference to the remaining FIGURES various embodiments in accordance with the present disclosure are set forth. It should be appreciated that the present embodiments are shown and described in connection with a certain electrical components, but that aspects of the present disclosure are adaptable to virtually any two mating electrical components. Accordingly, the specific electrical components in the illustrated embodiment are exemplary in nature.

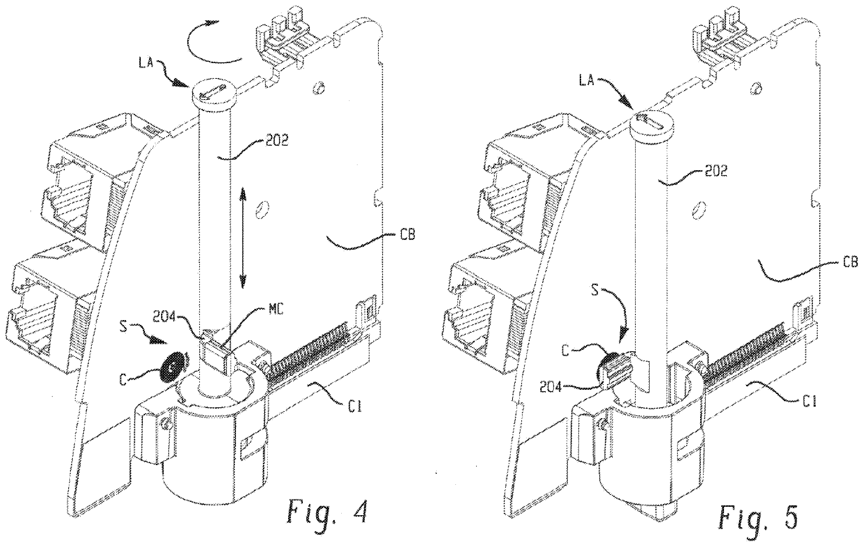

In FIGURES 4 and 5, a circuit board CB of an exemplary first electrical component in the form of a media card module in accordance with the present disclosure is illustrated. As will be appreciated, the circuit board CB is configured to be supported within a housing of a media card module. The circuit board CB includes an electrical connector C1 adapted for mating with a corresponding electrical connector of second electrical component, such as an I/O base. The circuit board CB supports a locking actuator LA and a sensor S. The sensor S in the illustrated embodiment includes an inductive coil C embedded in the circuit board CB and a metallic component MC supported on a radially-outwardly tangentially extending flange 204 of a shaft 202 of the locking actuator LA.

The shaft 202 is configured to be axially depressed from the unlocked position shown in FIGURE 4 and rotated clockwise 90 degrees to a locked position shown in FIGURE 5. In the unlocked position, the metallic component MC is spaced apart from the coil C. Upon movement of the locking actuator LA to the locked position, the metallic component MC is rotated into closer proximity to the coil C. The presence of the metallic component MC adjacent the coil C changes an inductance of the coil C which can be detected, for example, by a microprocessor of the circuit board CB in conventional fashion. In this embodiment, the metallic component MC moves axially and rotationally along with the shaft 202 of the locking actuator LA during actuation of the locking actuator LA, however, the perpendicular swinging motion of the metallic component MC is primarily responsible for the change in inductance of the coil C.

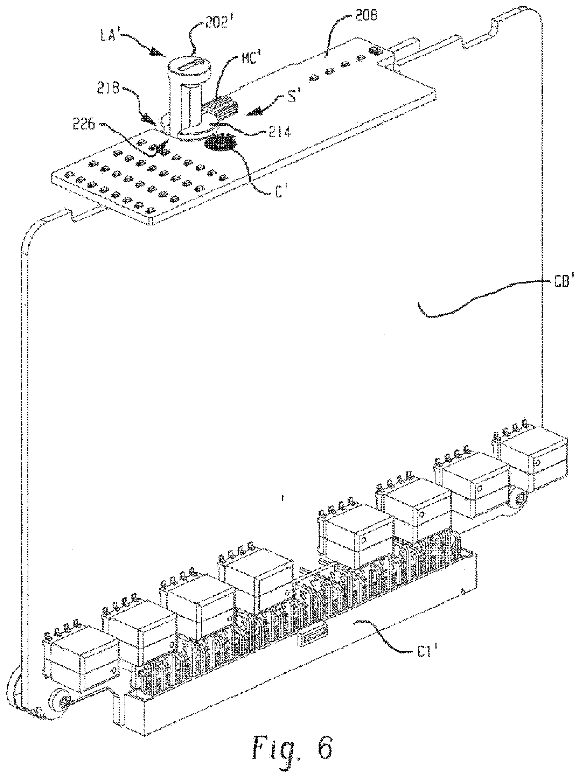

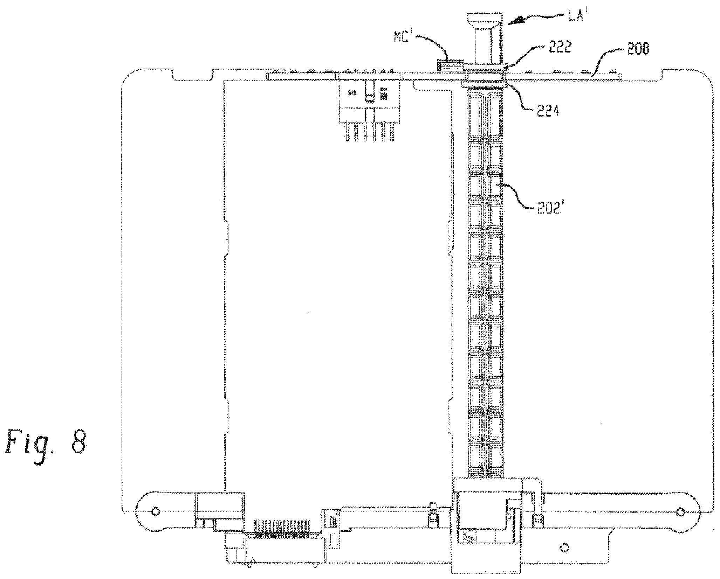

Turning to FIGURES 6-8, another exemplary embodiment of the present disclosure is illustrated. In this embodiment, a circuit board CB' of a first electrical component in the form of an I/O module supports a connector C1' for mating with a corresponding electrical connector of second electrical component (e.g., an I/O base) a locking actuator LA' and an auxiliary circuit board in the form of an LED board 208. A sensor S' includes an inductive coil C' embedded in the LED circuit board 208 and a metallic component MC' supported for rotation with a shaft 202' of the locking actuator LA' by a bushing or collar 214. The bushing 214 is received in a slot 218 in the LED circuit board 208 with upper and lower flanges 222 and 224 (see FIGURE 8) of the bushing 214 engaging opposite surfaces of the LED circuit board 208 such that the bushing 214 is fixed against axial movement relative to the LED circuit board 208. The shaft 202' is supported in a slot 226 of the bushing 214 such that the bushing 214 is rotationally interlocked with the shaft 202' of the locking actuator LA'.

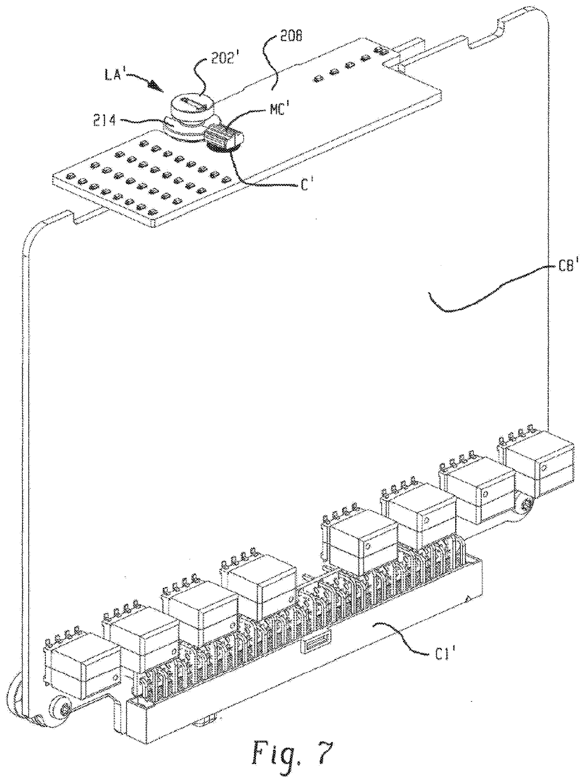

The locking actuator LA' is configured to be axially depressed from the unlocked position shown in FIGURES 6 and 8 and then rotated clockwise 90 degrees to a locked position shown in FIGURE 7. Through this motion, the metallic component MC' supported on the bushing 214 is rotated into position in close proximity to the coil C' causing a change in the inductance of the coil C'. In this embodiment, the metallic component C' is adapted to move rotationally with the shaft 202', but does not move axially with the shaft 202' when the shaft is depressed. Accordingly, aspects of the present embodiment, allow both vertical and rotational motion of the mechanical actuator while only transmitting rotational motion to the sensing device.

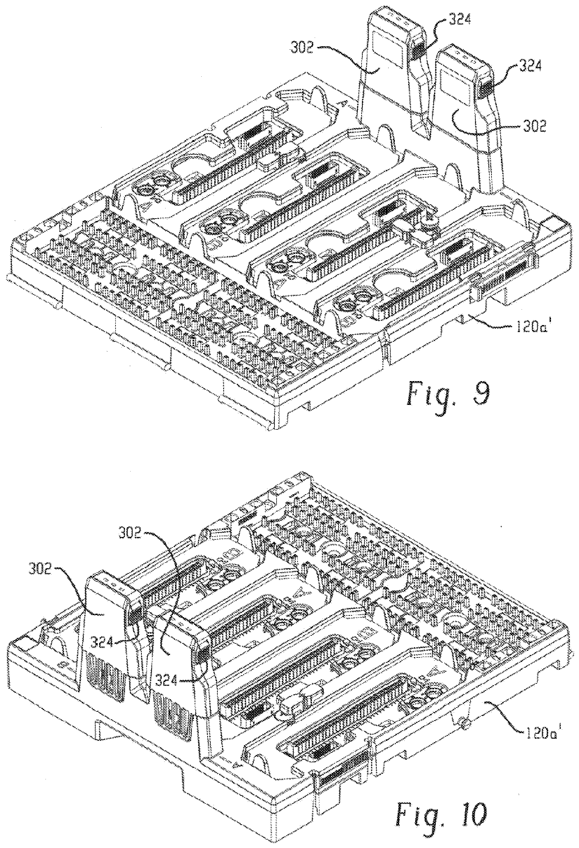

In FIGURES 9 and 10, an I/O base 120a' is illustrated with a pair of backplane interface modules (BIMs) 302 (also sometimes referred to as backplane switches) installed in respective ports of the I/O base 120a'. No I/O modules or terminal blocks are shown supported on the I/O base 120a' for clarity, but it will be appreciated that I/O modules and terminal blocks would typically otherwise be installed on the I/O base 120a'.

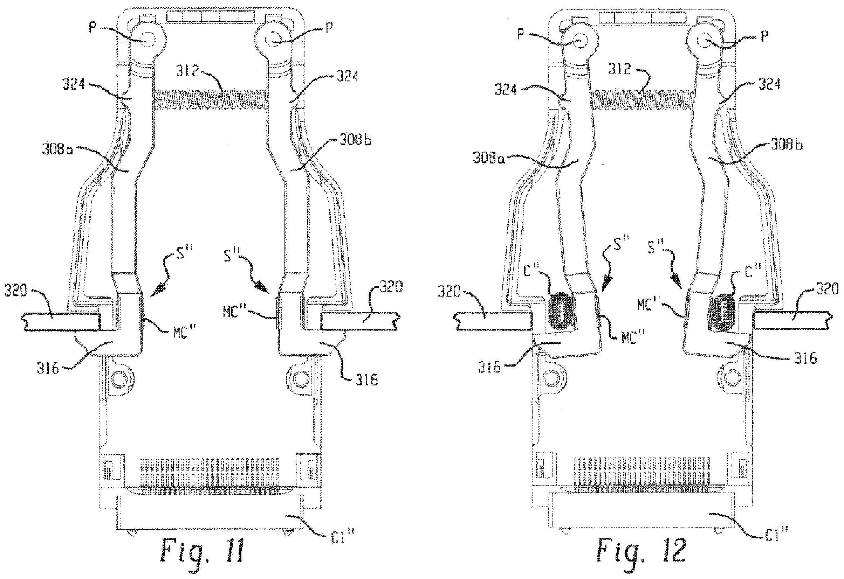

With additional reference to FIGURES 11 and 12, each BIM 302 includes an electrical connector C1" adapted to couple with a corresponding electrical connector (not shown) of the I/O base 120a'. Each BIM 302 further includes first and second latch arms 308a and 308b adapted to secure the BIM 302 to the I/O base 120a'. The latch arms 308a and 308b are spring-loaded towards a locked position shown in FIGURE 11 by a spring 312. A first end of each latch arm 308a and 308 b is supported by a pivot P. An opposite end of each latch arm 308a and 308b includes a latch flange 316 adapted to engage corresponding surface 320 of the I/O base 120a when in the position of FIGURE 11. Each latch arm 308a and 308b is movable from the locked position shown in FIGURE 11 to the unlocked position shown in FIGURE 12 by squeezing tabs 324. When tabs 324 are squeezed, the latch arms 308a and 308b, and, more particularly the latch flanges 316, are rotated towards each other.

It should be appreciated that a pair of sensors S" are provided for sensing a position of each of latch arms 308a and 308b. Each sensor S" includes an inductive coil C" and a metallic component MC' supported by a respective latch arm 308a or 308 b. In the illustrated embodiment, the metallic component is a metallic clip snap fit the latch arm. In other embodiments, the metallic component can be insert molded or plated on the latch arm. In the locked position of the latch arms 308a and 308b, the metallic component MC" is aligned in close proximity to the inductive coil C". When the latch arms 308a and 308b arc squeezed together to the unlocked position, the metallic component MC" is displaced laterally from the coil C" (e.g., a planar swinging motion). The resulting change in inductance of the coil C" is detected by, for example, a microprocessor of the BIM and can then be used as previously described to effect a shutdown routing or other action.

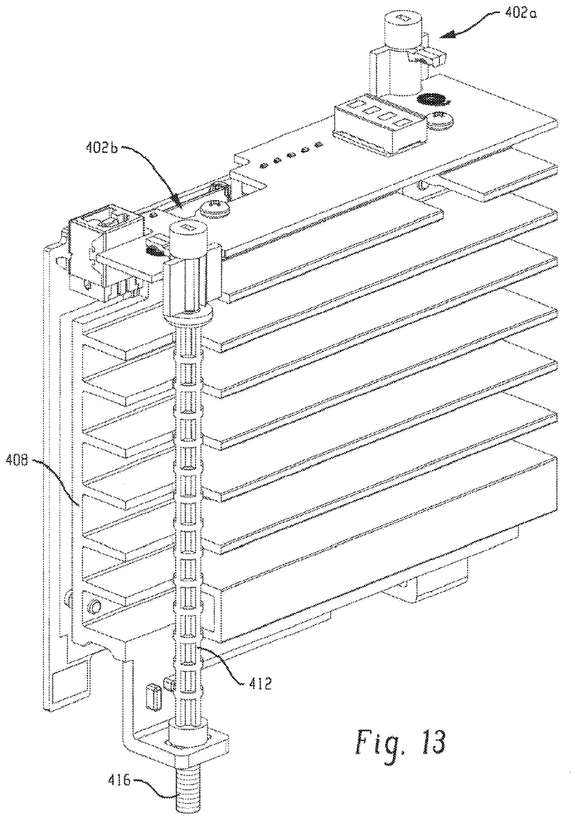

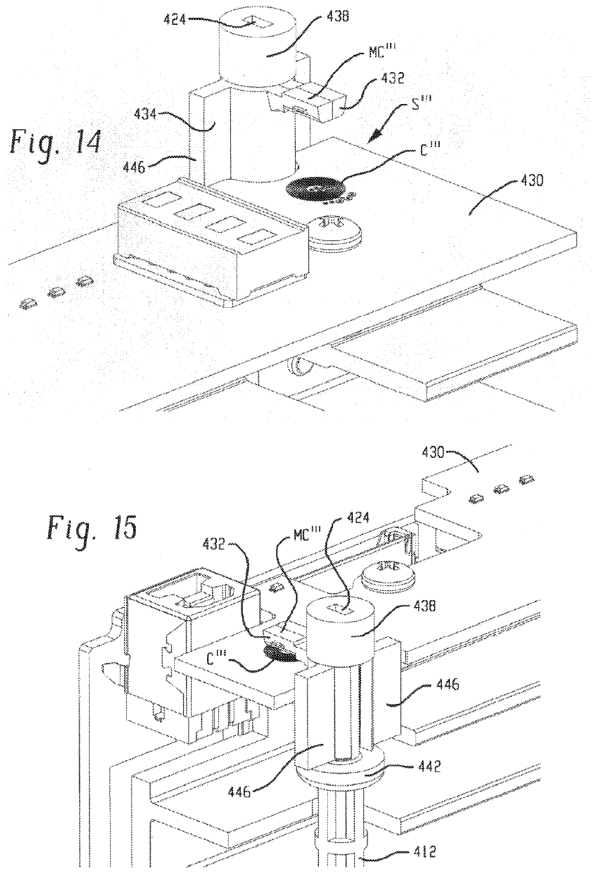

Turning to FIGURES 13-15, another exemplary embodiment is illustrated wherein a pair of screw-type locking actuators 402a and 402b are shown supported on an internal structure 408 of an electrical component, such as an I/O adapter. Each actuator 402a and 402b includes a shaft 412 having a threaded end 416 adapted to be screwed into a corresponding threaded bore of another electrical component, such as an I/O base, for example. Each shaft 412 includes a slot 424 adapted to receive a tool for rotating the shaft 412. As will be appreciated, the shaft 412 is shown in FIGURE 14 in an unlocked position and shown in FIGURE 15 in a locked position. The shaft 412 moves downwardly as the threaded end 416 is screwed into a corresponding threaded bore.

In this embodiment, a sensor S‴ is associated with each of the screw-type locking actuators 402a and 402b. Each sensor S‴ includes an inductive coil C‴ and a metallic component MC‴. Like the other embodiments, the inductive coil C‴ is provided in a circuit board 430 (e.g., LED circuit board) and is operatively coupled to a microprocessor or other device capable of monitoring an inductance of the coil C‴. The metallic component MC‴ is supported on a cantilevered protrusion 432 of a collar 434 that is fitted about the shaft 412. The collar 434 is captured on the shaft 412 between a head portion 438 and a radial flange 442 such that the collar 434 is adapted to move axially with the shaft 412 when it is screwed or unscrewed from a corresponding threaded bore to secure/release the electrical component. Outwardly extending wings 446 restrict rotation of the collar 434 (through interference with circuit board 430 and/or other adjacent structure) when the shaft 412 is rotated such that the metallic component MC‴ moves vertically towards and away from the coil C‴ as the shaft 412 is screwed into and out of the threaded bore of an associated electrical component.

It should now be appreciated that the metallic component MC‴ is moved from a first position spaced apart from the coil C‴ corresponding to an unlocked configuration of an actuator (FIGURE 14) to a second position in close proximity to the coil C‴ corresponding to a locked configuration of the actuator (FIGURE 15).

In certain embodiments wherein multiple locking actuator assemblies are present, redundant sensors can be used to prevent false trips by ensuring that both locking actuator assemblies are in an unlatched state before initiating any action based on the signals generated by the sensors. It should be appreciated the multiple sensors can be used in other configurations such as, for example, any application where first and second latching components are used.

Is should be appreciated that although an inductive coil is shown in the exemplary embodiments, other types of sensors can be used in accordance with aspects of the present disclosure including, for example, hall effect, photo interrupter, limit switch, etc.

Aspects of the present disclosure are adaptable to other types of locking actuator assemblies in addition to the locking actuators shown in the illustrated embodiments.

In the preceding specification, various embodiments have been described with reference to the accompanying drawings. It will, however, be evident that various modifications and changes may be made thereto, and additional embodiments may be implemented, without departing from the broader scope of the invention as set forth in the claims that follow. The specification and drawings are accordingly to be regarded in an illustrative rather than restrictive sense.

### The following is a list of further preferred embodiments of the invention:

Embodiment 1: An I/O system comprising:
   a first electrical component; and
   a second electrical component mechanically and electrically coupled with the first electrical component;
   wherein the second electrical component includes at least one locking actuator assembly having a locking actuator movable from a first unlocked position to a second locked position, the locking actuator configured to interlock with the first electrical component to secure the second electrical component to the first electrical component when in the second position; and
   a sensor for sensing a position of the locking actuator and generating a signal indicative of the position of the locking actuator.
Embodiment 2: The I/O system of embodiment 1, wherein the locking actuator assembly includes a shaft that is supported for rotation by the second electrical component and rotatable between the first and second positions, and wherein the sensor includes a coil supported by the second electrical component and a metallic component supported by the shaft, whereby the metallic component is spaced apart from the coil a greater distance when the locking actuator is in the first position than when the locking actuator is in the second position, whereby a change in the inductance of the coil corresponds to the signal indicative of the position of the locking actuator.
Embodiment 3: The I/O system of embodiment 2, wherein the coil extends in a plane parallel to a plane including the longitudinal axis of the shaft, the metallic component being supported on a radially extending flange of the shaft such that the metallic component is rotated towards the coil when the shaft is rotated from the first position to the second position and rotated away from the coil when the shaft is rotated from the second position to the first position.
Embodiment 4: The I/O system of embodiment 3, wherein the flange extends in a parallel plane to the coil when the shaft is in the second position, and extends in a non-parallel plane when the shaft is rotated from the second position towards the first position.
Embodiment 5: The I/O module of embodiment 4, wherein the metallic component includes a metallic clip secured to the flange.
Embodiment 6: The I/O system of embodiment 2, wherein the shaft is supported by the second electrical component for axial movement, the first unlocked position corresponding to a first axial position of the shaft and the second locked position corresponding to a second axial position of the shaft, wherein the metallic component is included with a collar that is fixed for rotation with the shaft, said collar fixed to the second electrical component against axial movement such that the shaft is movable axially relative to the collar, and wherein the coil is supported by the second electrical component in a location adjacent the collar, whereby the metallic component is spaced apart from the coil a greater distance when the locking actuator is in the first position than when the locking actuator is in the second position.
Embodiment 7: The I/O system of embodiment 6, wherein the collar is comprised of a composite material, and the metallic component includes a metallic clip secured to a flange of the collar.
Embodiment 8: The I/O system of embodiment 1, wherein the locking actuator assembly includes at least one latch arm supported by the second electrical component at a first end and having a latch flange spaced apart from the first end adapted to engage a surface of the first electrical component to thereby interlock the second electrical component with the first electrical component when the at least one latch arm is in the second position, the latch arm pivotable from the second position to the first position to disengage the latch flange from the first electrical component, and wherein the sensor includes a coil supported by the second electrical component and a metallic component supported by the latch arm, whereby the metallic component is spaced apart from the coil a greater distance when the locking actuator is in the first position than when the locking actuator is in the second position, whereby a change in the inductance of the coil corresponds to the signal indicative of the position of the locking actuator.
Embodiment 9: The I/O system of embodiment 1, wherein the second electrical component includes first and second locking actuator assemblies each having a locking actuator movable from a first unlocked position to a second locked position, the locking actuator configured to interlock with the first electrical component to secure the second electrical component to the first electrical component when in the second position; and
   a first and second sensors for sensing a position of a respective one of the locking actuators of the first and second locking actuator assemblies and generating signals indicative of the position of each locking actuator.
Embodiment 10: An electrical component comprising:
   a connecter for electrically coupling with a corresponding connector of an associated mating electrical component;
   a locking actuator assembly for mechanically interlocking the electrical component with the associated mating electrical component, the locking actuator assembly includes a locking actuator movable from a first unlocked position to a second locked position, the locking actuator configured to interlock with the associated electrical component when in the second position; and
   a sensor for sensing a position of the locking actuator and generating a signal indicative of the position of the locking actuator.
Embodiment 11: The electrical component of embodiment 10, wherein the locking actuator assembly includes a shaft that is supported for rotation by the electrical component and rotatable between the first and second positions, and wherein the sensor includes a coil supported by the electrical component and a metallic component supported by the shaft, whereby the metallic component is spaced apart from the coil a greater distance when the locking actuator is in the first position than when the locking actuator is in the second position, whereby a change in the inductance of the coil corresponds to the signal indicative of the position of the locking actuator.
Embodiment 12: The electrical component of embodiment 11, wherein the coil extends in a plane parallel to a plane including the longitudinal axis of the shaft, the metallic component being supported on a radially extending flange of the shaft such that the metallic component is rotated towards the coil when the shaft is rotated from the first position to the second position and rotated away from the coil when the shaft is rotated from the second position to the first position.
Embodiment 13: The electrical component of embodiment 12, wherein the flange extends in a parallel plane to the coil when the shaft is in the second position, and extends in a non-parallel plane when the shaft is rotated from the second position towards the first position.
Embodiment 14: The electrical component of embodiment 13, wherein the metallic component includes a metallic clip secured to the flange.
Embodiment 15: The electrical component of embodiment 11, wherein the shaft is supported by the electrical component for axial movement, the first unlocked position corresponding to a first axial position of the shaft and the second locked position corresponding to a second axial position of the shaft, wherein the metallic component is included with a collar that is fixed for rotation with the shaft, said collar fixed to the electrical component against axial movement such that the shaft is movable axially relative to the collar, and wherein the coil is supported by the electrical component in a location adjacent the collar, whereby the metallic component is spaced apart from the coil a greater distance when the locking actuator is in the first position than when the locking actuator is in the second position.
Embodiment 16: The electrical component of embodiment 15, wherein the collar is comprised of a composite material, and the metallic component includes a metallic clip secured to a flange of the collar.
Embodiment 17: The electrical component of embodiment 11, wherein the locking actuator assembly includes at least one latch arm supported by the electrical component at a first end and having a latch flange spaced apart from the first end adapted to engage a surface of the associated mating electrical component to thereby interlock the electrical component with the associated mating electrical component when the at least one latch arm is in the second position, the latch arm pivotable from the second position to the first position to disengage the latch flange from the associated mating electrical component, and wherein the sensor includes a coil supported by the electrical component and a metallic component supported by the latch arm, whereby the metallic component is spaced apart from the coil a greater distance when the locking actuator is in the first position than when the locking actuator is in the second position, whereby a change in the inductance of the coil corresponds to the signal indicative of the position of the locking actuator.
Embodiment 18: The electrical component of embodiment 10, wherein the sensor includes at least one of an inductive coil, a hall effect sensor, a photo interrupter, or a limit switch.
Embodiment 19: A method of determining a coupling state of a first electrical component with a second electrical component comprising:
   sensing a position of a first locking actuator assembly of the first electrical component using a first sensor, and generating a first signal indicative of the position of the first locking actuator assembly;
   wherein the first locking actuator assembly includes a first locking actuator movable from a first unlocked position to a second locked position, the locking actuator configured to interlock the first electrical component with the second electrical component when in the second position; and
   wherein the first sensor includes a coil supported by the first electrical component and a metallic component supported by first locking actuator, whereby the metallic component is spaced apart from the coil a greater distance when the first locking actuator is in the first position than when the first locking actuator is in the second position, whereby a change in the inductance of the coil corresponds to the signal indicative of the position of the first locking actuator.
Embodiment 20: The method of embodiment 19, further comprising sensing a position of a second locking actuator assembly of the first electrical component using a second sensor, and generating a second signal indicative of the position of the second locking actuator assembly, wherein the second locking actuator assembly includes a second locking actuator movable from a first unlocked position to a second locked position, the second locking actuator configured to interlock the first electrical component with the second electrical component when in the second position, and wherein the second sensor includes a coil supported by the first electrical component and a metallic component supported by second locking actuator, whereby the metallic component is spaced apart from the coil a greater distance when the second locking actuator is in the first position than when the second locking actuator is in the second position, whereby a change in the inductance of the coil corresponds to the signal indicative of the position of the second locking actuator, and comparing the first and second signals to determine whether the first electrical component is interlocked with the second electrical component.

## Claims

1. An I/O system comprising:
a first electrical component; and
a second electrical component mechanically and electrically coupled with the first electrical component;
wherein the second electrical component includes at least one locking actuator assembly having a locking actuator movable from a first unlocked position to a second locked position, the locking actuator configured to interlock with the first electrical component to secure the second electrical component to the first electrical component when in the second position; and
a sensor for sensing a position of the locking actuator and generating a signal indicative of the position of the locking actuator.

2. The I/O system of claim 1, wherein the locking actuator assembly includes a shaft that is supported for rotation by the second electrical component and rotatable between the first and second positions, and wherein the sensor includes a coil supported by the second electrical component and a metallic component supported by the shaft, whereby the metallic component is spaced apart from the coil a greater distance when the locking actuator is in the first position than when the locking actuator is in the second position, whereby a change in the inductance of the coil corresponds to the signal indicative of the position of the locking actuator.

3. The I/O system of claim 2, wherein the coil extends in a plane parallel to a plane including the longitudinal axis of the shaft, the metallic component being supported on a radially extending flange of the shaft such that the metallic component is rotated towards the coil when the shaft is rotated from the first position to the second position and rotated away from the coil when the shaft is rotated from the second position to the first position.

4. The I/O system of claim 3, wherein the flange extends in a parallel plane to the coil when the shaft is in the second position, and extends in a non-parallel plane when the shaft is rotated from the second position towards the first position; and/or
wherein the metallic component includes a metallic clip secured to the flange.

5. The I/O system of claim 2, wherein the shaft is supported by the second electrical component for axial movement, the first unlocked position corresponding to a first axial position of the shaft and the second locked position corresponding to a second axial position of the shaft, wherein the metallic component is included with a collar that is fixed for rotation with the shaft, said collar fixed to the second electrical component against axial movement such that the shaft is movable axially relative to the collar, and wherein the coil is supported by the second electrical component in a location adjacent the collar, whereby the metallic component is spaced apart from the coil a greater distance when the locking actuator is in the first position than when the locking actuator is in the second position; and/or
wherein the collar is comprised of a composite material, and the metallic component includes a metallic clip secured to a flange of the collar.

6. The I/O system of one of claims 1 to 5, wherein the locking actuator assembly includes at least one latch arm supported by the second electrical component at a first end and having a latch flange spaced apart from the first end adapted to engage a surface of the first electrical component to thereby interlock the second electrical component with the first electrical component when the at least one latch arm is in the second position, the latch arm pivotable from the second position to the first position to disengage the latch flange from the first electrical component, and wherein the sensor includes a coil supported by the second electrical component and a metallic component supported by the latch arm, whereby the metallic component is spaced apart from the coil a greater distance when the locking actuator is in the first position than when the locking actuator is in the second position, whereby a change in the inductance of the coil corresponds to the signal indicative of the position of the locking actuator.

7. The I/O system of one of claims 1 to 6, wherein the second electrical component includes first and second locking actuator assemblies each having a locking actuator movable from a first unlocked position to a second locked position, the locking actuator configured to interlock with the first electrical component to secure the second electrical component to the first electrical component when in the second position; and
a first and second sensors for sensing a position of a respective one of the locking actuators of the first and second locking actuator assemblies and generating signals indicative of the position of each locking actuator.

8. An electrical component comprising:
a connecter for electrically coupling with a corresponding connector of an associated mating electrical component;
a locking actuator assembly for mechanically interlocking the electrical component with the associated mating electrical component, the locking actuator assembly includes a locking actuator movable from a first unlocked position to a second locked position, the locking actuator configured to interlock with the associated electrical component when in the second position; and
a sensor for sensing a position of the locking actuator and generating a signal indicative of the position of the locking actuator.

9. The electrical component of claim 8, wherein the locking actuator assembly includes a shaft that is supported for rotation by the electrical component and rotatable between the first and second positions, and wherein the sensor includes a coil supported by the electrical component and a metallic component supported by the shaft, whereby the metallic component is spaced apart from the coil a greater distance when the locking actuator is in the first position than when the locking actuator is in the second position, whereby a change in the inductance of the coil corresponds to the signal indicative of the position of the locking actuator.

10. The electrical component of claim 9, wherein the coil extends in a plane parallel to a plane including the longitudinal axis of the shaft, the metallic component being supported on a radially extending flange of the shaft such that the metallic component is rotated towards the coil when the shaft is rotated from the first position to the second position and rotated away from the coil when the shaft is rotated from the second position to the first position; and/or
wherein the flange extends in a parallel plane to the coil when the shaft is in the second position, and extends in a non-parallel plane when the shaft is rotated from the second position towards the first position; and/or
wherein the metallic component includes a metallic clip secured to the flange.

11. The electrical component of claim 9 or 10, wherein the shaft is supported by the electrical component for axial movement, the first unlocked position corresponding to a first axial position of the shaft and the second locked position corresponding to a second axial position of the shaft, wherein the metallic component is included with a collar that is fixed for rotation with the shaft, said collar fixed to the electrical component against axial movement such that the shaft is movable axially relative to the collar, and wherein the coil is supported by the electrical component in a location adjacent the collar, whereby the metallic component is spaced apart from the coil a greater distance when the locking actuator is in the first position than when the locking actuator is in the second position; and/or
wherein the collar is comprised of a composite material, and the metallic component includes a metallic clip secured to a flange of the collar.

12. The electrical component of one of claims 9 to 11, wherein the locking actuator assembly includes at least one latch arm supported by the electrical component at a first end and having a latch flange spaced apart from the first end adapted to engage a surface of the associated mating electrical component to thereby interlock the electrical component with the associated mating electrical component when the at least one latch arm is in the second position, the latch arm pivotable from the second position to the first position to disengage the latch flange from the associated mating electrical component, and wherein the sensor includes a coil supported by the electrical component and a metallic component supported by the latch arm, whereby the metallic component is spaced apart from the coil a greater distance when the locking actuator is in the first position than when the locking actuator is in the second position, whereby a change in the inductance of the coil corresponds to the signal indicative of the position of the locking actuator.

13. The electrical component of one of claims 9 to 12, wherein the sensor includes at least one of an inductive coil, a hall effect sensor, a photo interrupter, or a limit switch.

14. A method of determining a coupling state of a first electrical component with a second electrical component comprising:
sensing a position of a first locking actuator assembly of the first electrical component using a first sensor, and generating a first signal indicative of the position of the first locking actuator assembly;
wherein the first locking actuator assembly includes a first locking actuator movable from a first unlocked position to a second locked position, the locking actuator configured to interlock the first electrical component with the second electrical component when in the second position; and
wherein the first sensor includes a coil supported by the first electrical component and a metallic component supported by first locking actuator, whereby the metallic component is spaced apart from the coil a greater distance when the first locking actuator is in the first position than when the first locking actuator is in the second position, whereby a change in the inductance of the coil corresponds to the signal indicative of the position of the first locking actuator.

15. The method of claim 14, further comprising sensing a position of a second locking actuator assembly of the first electrical component using a second sensor, and generating a second signal indicative of the position of the second locking actuator assembly, wherein the second locking actuator assembly includes a second locking actuator movable from a first unlocked position to a second locked position, the second locking actuator configured to interlock the first electrical component with the second electrical component when in the second position, and wherein the second sensor includes a coil supported by the first electrical component and a metallic component supported by second locking actuator, whereby the metallic component is spaced apart from the coil a greater distance when the second locking actuator is in the first position than when the second locking actuator is in the second position, whereby a change in the inductance of the coil corresponds to the signal indicative of the position of the second locking actuator, and comparing the first and second signals to determine whether the first electrical component is interlocked with the second electrical component.
